# EUROPEAN PATENT SPECIFICATION

(11) **EP 3 405 795 B1**
(45) Date of publication and mention of the grant of the patent: **13.04.2022**
(21) Application number: 17701558.3
(22) Date of filing: 18.01.2017
(51) Int. Cl.: G01R 1/22, G01R 15/20, G01R 15/18

(54) **MEASUREMENT DEVICE**
MESSVORRICHTUNG
DISPOSITIF DE MESURE

(30) Priority: 22.01.2016 GB 201601188
(43) Date of publication of application: 28.11.2018
(73) Proprietor: GMC-I Prosys Ltd., Skelmersdale, Lancashire WN8 9PH (GB)
(72) Inventor: GOULDSON, Dean, Skelmersdale Lancashire WN8 9PH (GB); MAHON, James, Skelmersdale Lancashire WN8 9PH (GB); JACYNA, Geoffrey, Skelmersdale Lancashire WN8 9PH (GB)
(74) Representative: Stott, James Edward
(86) International application number: PCT/GB2017/050109
(87) International publication number: WO 2017/125728

(56) References cited:
- EP-A1- 2 083 277
- JP-A- H0 318 765
- US-A1- 2012 217 963
- US-A1- 2013 063 140

## Description

The present invention relates to a measurement device, and, in particular, to a magnetic field measurement device, for example a magnetic field measuring probe. More specifically the present invention relates to a split-core fluxgate probe.

Current sensing equipment may be used to measure the electrical current flowing through a current carrying conductor. It is desirable to sense electrical current without a direct electrical connection to the conductor carrying the current to be sensed, so as to avoid any electrical disturbances to the current to be sensed which may interfere with the current measurement, and also so as to avoid the possibility of the current to be sensed from being transferred to the current sensing equipment and thence to a user, which may present a hazard. In order to allow current measurement of this kind, it is known to use a sensor (or measurement device) operable to measure properties of the magnetic field produced by the current to be measured travelling through a conductor, from which the properties of the current itself can be deduced. It is known to provide such a sensor in the form of a magnetic field sensor such as, for example: a Hall Effect sensor, a MEMS-based magnetic field sensor, or a fluxgate sensor.

Fluxgate current sensors are usually used for measuring a wide dynamic range from µA to 100's of Amps and may, for example be used to detect currents with a motor drive.

Fluxgate type sensors are particularly useful in which the current being carried by a conductor is relatively high and the sensitivity required in measuring the current is also relatively high. For example, a locomotive driven by motor may utilise a drive current provided to the motor which is in excess of 1000A. It may be desirable to measure a leakage current in this system in the order of milliamps.

US 2013/063140 A1 discloses a magnetic sensor which includes two sensor units with curved cores including meshing portions at front and base ends thereof and constructs a ring when the meshing portions mesh together.

JP HO3-18765 A discloses a magnetic sensor which converges a magnetic field produced by a conductor to be measured by a magnetic core and outputs a voltage, in order to minimize a measurement error when the conductor to be measured is not accurately located in the centre of the magnetic core.

US 2012/217963 A1 discloses a magnetic core to be used in a current sensor. The magnetic core includes a first open end plane, which has a first element holding hole for holding a magnetoelectric conversion element formed therein, and a second open end plane, which has a second element holding hole for holding the magnetoelectric conversion element formed therein and which faces the first open end plane.

EP 2083277 A1 discloses a closed-loop current sensor comprising a magnetic circuit ,a magnetic field sensor, and a compensation circuit configured to generate a magnetic field opposing a magnetic field created by an electrical current to be measured flowing in one or more primary conductors extending through a central opening of the magnetic circuit.

EP1340092 discloses one such current sensor which comprises a pair of linear fluxgates arranged to sense the strength of the magnetic field of a current carrying conductor. The fluxgate current sensor comprises separable jaws, each jaw further comprising a core portion composed of a high magnetic permeability material (e.g. nickel iron). The separable nature of the jaws allows the cores to be placed around the current carrying conductor within which the current is desired to be sensed. The jaws of the current sensor are configured so that when the jaws are closed against one another the ends of both cores align to form a core - a near continuous loop of high magnetic permeability material. Such an arrangement is known as a "split core" type sensor.

Non-split core fluxgate current sensors may also be used to sense the current within a current carrying conductor. Fluxgate current sensors of the non-split core type typically comprise a single core of high magnetic permeability material formed as a continuous loop. Because of the non-split nature of the core of this type of fluxgate current sensor, this type of current sensor usually has to be installed around the current carrying conductor whilst the conductor is not carrying any current - for example, when the conductor is first installed or as part of an installation routine in which the conductor is powered down.

With regard to the split core type current measurement device of EP1340092, each core portion comprises a recess formed on its surface, within which a linear fluxgate sensor is positioned. The fluxgate sensors themselves are formed of a high magnetic permeability rod upon which a wire coil is wound, the ends of each of which are fed to a sensing circuit and connected differentially so as to respond to a differential magnetic field produced by the current carrying conductor. A drive winding (or compensation coil) is wound around at least a portion of the core and is used to induce a magnetic field within the core when an electrical current is applied to the drive winding.

The two fluxgate sensors (which may also be referred to as fluxgate coils or fluxgate sensing elements) are driven in parallel at an appropriate frequency (for example 120Khz). Each fluxgate sensor is in series with a capacitor and thereby tuned to resonance. The output voltages across the two capacitors are fed to a differential amplifier and subtracted. The reason for this is that the two fluxgate sensors do not attain saturation simultaneously, because they are both exposed to different external earth field values.

Consequently, the second harmonic signals measured across the two capacitors are not in phase. If these two signals are subtracted, then the carrier signals will cancel out and only the second harmonic signals will remain. These second harmonic signals are then rectified on both the positive and negative peaks and the resulting DC offsets are summed to zero through an integrator. The phase shift is detected as a DC offset change, because the system comprises a carrier that is both phase and amplitude modulated.

The integrator drives a power output stage which drives the compensation coil. The magnetic field produced within the core by the compensation coil acts in substantially the opposite direction to the magnetic field produced in the cores by the sensed current. If the magnitude of the magnetic field produced within the core by the drive winding is equal to that of the magnetic field produced in the core by the sensed current the two magnetic fields cancel one another to create a so called "null field". The presence of the null field is determined when the output voltage of the fluxgate sensors is substantially zero. The electrical current applied to the drive winding is therefore proportional to the electrical current that is to be sensed, and may thus be used to determine value of the sensed current.

Any external magnetic field permeating the core of the fluxgate current sensor may result in the output of the sensor not accurately reflecting the current flowing through the conductor. External magnetic fields are those magnetic fields that are not produced as a result of the current to be sensed flowing through the conductor, such as, for example, the magnetic field of the Earth. In an equivalent manner, in general, any external magnetic field permeating the core of a magnetic sensor may result in the output of the sensor not accurately reflecting the property that the magnetic sensor is configured to measure.

It is known that the position of the fluxgates within the core of the current sensor can affect the accuracy of the sensor readings.

As previously discussed, fluxgate current sensors may be required to exhibit great sensitivity, for example electrical currents of the order of 10⁻⁶A (micro-Amps), whilst the current flowing through the current carrying conductor is very large, for example up to 10³ A (kilo-Amps). It will be appreciated that to exhibit great sensitivity, the accuracy of the current sensor is of high importance. Additionally, when measuring large currents the safety of the current sensor is of high importance - i.e. it is important that, if the sensor comes into contact with hazardous live voltages, the sensor does not act as a path for the high potential to be conducted to the user of the sensor thereby putting the user of the sensor at risk of electrocution.

It is an object of the present invention to obviate or mitigate at least one of the above the above outlined shortcomings of known fluxgate current sensors. It is a further object of the present invention to provide an alternative configuration of a fluxgate current sensor. It is a further object of the invention to provide a magnetic sensor which is less susceptible to external magnetic fields. The invention is set out in the appended set of claims.

According to a first aspect of the invention there is provided a split-core current measurement device comprising: a first arm including a first magnetic core portion; a second arm including a second magnetic core portion; a first sensing element; the first and second magnetic core portions being shaped so that, when the first and second arms of the measurement device are in a closed configuration, the first and second magnetic core portions cooperate to form a substantially complete magnetic circuit configured to act as a flux guide when the measurement device surrounds a current carrying conductor; wherein the first magnetic core portion includes a first non-magnetic core discontinuity; and wherein the first magnetic core portion defines a first internal cavity within which the first sensing element is contained such that at least a portion of the first sensing element is located in the first non-magnetic core discontinuity.

The first sensing element may be a fluxgate sensing element. The split-core current measurement device may be a split-core fluxgate current measurement device.

The first non-magnetic core discontinuity is such that, when the first and second arms are in the closed configuration in order to form a substantially complete magnetic circuit which acts as a flux guide when the measurement device surrounds a current carrying conductor, the first non-magnetic core discontinuity acts as a gap or discontinuity in the core such that a fringing field is formed at the first non-magnetic core discontinuity. It follows that, when the measurement device surrounds a current carrying conductor, at least a portion of the first fluxgate sensing element is located in the fringing field formed at the first non-magnetic core discontinuity. The first non-magnetic core discontinuity is said to be non-magnetic because it is a region having a relatively low magnetic permeability µ (compared to that of the core). For example, in one embodiment, the core is formed from a material having relatively high magnetic permeability (e.g. nickel iron, a relative permeability µᵣ of about 70000 to about 150000) and the first non-magnetic core discontinuity may comprise polycarbonate having µ approximately equal to µ₀ (the permeability of free space). In other embodiments, the first non-magnetic core discontinuity may comprise air having µ approximately equal to µ₀. The first non-magnetic core discontinuity may comprise a region/material having a relatively low magnetic permeability of approximately µ₀. The first non-magnetic core discontinuity may comprise a region/material having a magnetic permeability which is less than that of the material which forms the first and/or second magnetic core portions.

By placing the fluxgate sensing element within an internal cavity this ensures that the fluxgate is screened on all sides. Furthermore, locating the fluxgate sensing element within a cavity at the location of the core discontinuity ensures that the fluxgate sensing element lies, in use, within a homogeneous portion of a fringing field of measurement device. Positioning fluxgate sensing elements in this way (particularly in each of the two arms of the measurement device) improves positional sensitivity and external field rejection due to the magnetic field being homogeneous in the centralised area of the core discontinuity in which each fluxgate sensing element is located. Common mode field rejection is improved by this topology, hence providing improved external field rejection.

The "positional sensitivity" is a performance parameter of the measurement device, and indicates a degree of variation in the output of the measurement device as a result of a positioning change of the current-carrying conductor with respect to the measurement device. It will be appreciated that small positional sensitivity is generally desired. The "external field" refers to external magnetic field not produced as a result of the current to be sensed which flows through the conductor, and includes, for example, the magnetic field of the Earth. With improved external field rejection, the undesired effect caused by the external field to the output of the measurement device is reduced and the accuracy of the output of the measurement device is improved.

The first fluxgate sensing element may be contained within the first internal cavity such that the first magnetic core portion encloses the first fluxgate sensing element in three dimensions.

The first fluxgate sensing element may have a longitudinal axis and four side surfaces substantially along the longitudinal axis. The first fluxgate sensing element may be contained within the first internal cavity such that the first magnetic core portion encloses each of the four side surfaces of the first fluxgate sensing element. The first fluxgate sensing element may have two end surfaces substantially perpendicular to the longitudinal axis. The first fluxgate sensing element may be contained within the first internal cavity such that the first magnetic core portion encloses each of the two end surfaces of the first fluxgate sensing element.

The first non-magnetic core discontinuity may extend through a cross-section of the first magnetic core portion entirely. The first magnetic core portion may have a general axis of revolution. The cross-section of the first magnetic core portion may be perpendicular to the general axis of revolution.

The first magnetic core portion comprises separate first and second sectors. The first and second sectors are separated by the first non-magnetic core discontinuity.

The provision of first and second sectors enables the fluxgate to be placed within the first magnetic core portion.

The first internal cavity may be defined by both the first sector and the second sector.

The measurement device may further comprise a first support member, the first support member supporting the first fluxgate sensing element within the first internal cavity.

The first magnetic core portion may have a general axis of revolution, wherein the first internal cavity lies on the general axis of revolution, wherein the first fluxgate sensing element has a longitudinal axis, and wherein the first support member is configured to support the first fluxgate sensing element within the first internal cavity such that the first fluxgate sensing element is centralised within the first magnetic core portion whereby the longitudinal axis of the fluxgate sensing element lies on the general axis of revolution of the first magnetic coil portion.

By centralising the fluxgate sensor within the magnetic coil portion this ensures that the fluxgate sensor is centralised in the magnetic flux within the core (and, in particular, is located in a homogeneous portion of the fringing field in the core discontinuity), thereby improving the accuracy of the current measurements taken using the fluxgate.

The support member may be formed from an electrically insulating material.

The first support member may enclose the first fluxgate sensing element in three dimensions such that an unintended electrical path between the first fluxgate sensing element and the first magnetic core portion is substantially prevented. The first support member may enclose each of the four side surfaces of the first fluxgate sensing element. The first support member may further enclose each of the two end surfaces of the first fluxgate sensing element.

A first electrical isolation (safety creepage and clearance) is achieved via the support member (in addition to the tube surrounding the fluxgate wires and the inner sheath - discussed in more detail below). This electrical isolation separates the core from the fluxgate winding.

The support member may be formed at least in part from a non-magnetic material. The support member may form at least part of the first non-magnetic core discontinuity.

The support member may be said to create a magnetic clearance between the first and second sectors. As such, the support member may define a fixed magnetic clearance between the first and second sectors of the core. By providing a consistent gap in the magnetic circuit provided by the core, the support member results in a uniform magnetic flux fringing field in the proximity of the fluxgate sensor (a part of which is located in the magnetic clearance between the first and second sectors), thereby providing a higher uniformity in the magnetic flux pattern. By providing a higher uniformity in the magnetic flux pattern, the flux measured by the fluxgate sensors will more accurately reflect the flux in the core, and hence the flux produced by the current carrying conductor, thereby improving the sensitivity of the measurement device.

The second magnetic core portion may define a second internal cavity within which a second fluxgate sensing element is contained. At least a portion of the second fluxgate sensing element may be located in a second non-magnetic core discontinuity. More broadly, although only features of the first arm have been discussed above, the second arm may have features which are identical to those of the first arm - including at least one of a second cavity, a second fluxgate sensing element, third and fourth core sectors, a second support member etc. In particular, by providing a second fluxgate sensing element within a second cavity of the second arm, the symmetry of the measurement device is improved, thereby further improving positional sensitivity of the measurement device. In this way, the sensitivity of an output of the measurement device in response to a change of conductor positioning within the measurement device when in use can be reduced.

The first and second magnetic core portions may be separable. As such, the core may be referred to as a split core and the measurement device may be referred to as a split core split-core fluxgate current sensing device.

The first magnetic core portion may comprise a stack of first laminations. The first laminations may be arranged in a crenelated fashion at a first end of the first magnetic core portion.

The second magnetic core portion may comprise a stack of second laminations. The second laminations may be arranged in a crenelated fashion opposite to that of the first laminations at a first end of the second magnetic core portion, such that the first laminations mate to the second laminations when the first and second arms are in a closed configuration.

The crenelated arrangement of the first and second laminations reduces the errors in engaging the first and second arms, resulting in easier manufacture and reduced performance errors caused by temperature, misalignment and long term wear and tear. Such errors are commonly seen on measurement devices which use flat metal mating faces at the separation of the two arms.

According to a second, unclaimed, aspect of the invention there is provided a method of assembling a split-core fluxgate current sensing device, the measurement device comprising a first arm including a first magnetic core portion; a second arm including a second magnetic core portion; a first fluxgate sensor; the first and second magnetic core portions being shaped so that, when the first and second arms of the measurement device are in a closed configuration, the first and second magnetic core portions cooperate to form a substantially complete magnetic circuit configured to act as a flux guide when the measurement device surrounds a current carrying conductor; wherein the first magnetic core portion includes a first non-magnetic core discontinuity and wherein the first magnetic core portion defines a first internal cavity; wherein the method comprises inserting the first fluxgate sensing element into the first internal cavity such that at least a portion of the first fluxgate sensing element is located in the first non-magnetic core discontinuity.

The first magnetic core portion may comprise separate first and second sectors; and the method may comprise inserting the first fluxgate sensing element into the first sector, and bringing the first and second sectors together to form the first internal cavity and to enclose the first fluxgate sensing element within the first internal cavity.

The measurement device may further comprise a first support member, and the method may comprise the first support member supporting the first fluxgate sensing element and inserting at least part of the first support member into the first internal cavity.

The support member may be formed at least in part from a non-magnetic material. The support member may form at least part of the first non-magnetic core discontinuity.

According to a third aspect of the invention there is provided a split-core magnetic measurement device comprising: a first arm including a first magnetic core portion and a first magnetic shield portion; a second arm including a second magnetic core portion and a second magnetic shield portion; a sensor element sensitive to changes in magnetic field; the first and second magnetic core portions being shaped so that, when the first and second arms of the measurement device are in a closed configuration, the first and second magnetic core portions cooperate to form a substantially complete magnetic circuit configured to act as a flux guide when the measurement device surrounds a current carrying conductor; and the first and second magnetic shield portions being shaped so that, when the first and second arms of the measurement device are in a closed configuration, the first and second magnetic shield portions cooperate to form a second substantially complete magnetic circuit which encloses the first and second magnetic core portions and is configured to act as a magnetic shield which acts, when the measurement device surrounds a current carrying conductor, to minimise flux other than the flux of the current carrying conductor from passing through the first and second magnetic core portions.

Minimising flux other than the flux of the current carrying conductor from passing through the first and second magnetic core portions will result in improved accuracy of the sensor because the effect of flux other than the flux of the current carrying conductor on the sensor will be minimised.

When it is said that the measurement device is a magnetic measurement device, what is meant is that the measurement device can measure or sense magnetic field.

Although the first and second aspects of the invention relate to a split-core fluxgate current sensing device, the third aspect of the invention not only applies to a split-core fluxgate current sensing device, but also to any magnetic sensor measurement device which includes a magnetic core. Examples include, but are not limited to, a Hall Effect measurement device and a MEMS type measurement device. The person skilled in the art would have no difficulty in applying the present invention to any appropriate type of magnetic sensor. In the case where the sensor measurement device is a split-core fluxgate current sensing device, the sensor element may be a fluxgate (also referred to as a fluxgate sensing element). The person skilled in the art may select any appropriate sensor element depending on the type of the magnetic sensor.

The first and second magnetic shield portions may be shaped so that, when the first and second arms of the measurement device are in a closed configuration, a first end of the first magnetic shield portion overlaps with a first end of the second magnetic shield portion. An overlap of the first end of the first magnetic shield portion and the first end of the second magnetic shield portion may substantially surround a separation between the first and second magnetic core portions when the measurement device is in a closed configuration.

This overlap ensures that the magnetic core is totally encapsulated and ensures that the separation between the first and second core portions when the measurement device is in the closed configuration is magnetically screened. That is to say, because of the overlap, there is an effective double layer of magnetic shielding at the separation between the first and second core portions when the measurement device is in the closed configuration.

When the first and second arms of the measurement device are in a closed configuration, the first and second magnetic shield portions may have a general axis of revolution and the first end of the first magnetic shield portion may overlap with the first end of the second magnetic shield portion in a direction parallel to the general axis of revolution at the first end of the first magnetic shield portion and at the first end of the second magnetic shield portion.

When the first and second arms of the measurement device are in a closed configuration, the first and second magnetic shield portions may have a general axis of revolution and the first end of the first magnetic shield portion may overlap with the first end of the second magnetic shield portion such that there is no line of sight between the first end of the first magnetic shield portion and the first end of the second magnetic shield portion in a direction generally perpendicular to the general axis of revolution at the first end of the first magnetic shield portion and at the first end of the second magnetic shield portion.

When the first and second arms of the measurement device are in a closed configuration, the first and second magnetic shield portions may have a general axis of revolution, and a first diameter of the first end of the first magnetic shield portion relative to the general axis of revolution may be greater than a second diameter of the first end of the second magnetic shield portion, such that, when the first and second arms of the measurement device are in a closed configuration the first end of the second magnetic shield portion is received within the first end of the first magnetic shield portion.

There may be a clearance between the first end of the second magnetic shield portion and the first end of the first magnetic shield portion. The clearance between the first and second shield portions may have several benefits. First, the clearance between the first and second shield portions may increase the apparent saturation levels of the shield. The increase in saturation levels will reduce the effective permeability of the shield thus resulting in shearing of the B-H properties, thereby reducing the remanence effects. This has the benefit of making the measurement device less susceptible to high external currents and enabling the measurement device to measure high internal currents. Secondly, because there is a clearance between the first and second shield portions, there is no continuous magnetic circuit formed by the shield, again, as referred to above, this will improve the remanence of the shield. Thirdly, because of the clearance between the first and second shield portions, there is effectively a double layer of magnetic shielding at the separation between the first and second core portions when the measurement device is in the closed configuration. The double layer of magnetic shielding improves external field rejection within the measurement device. Finally, the clearance between the first and second shield portions will reduce wear and tear on the shield portions because the shield portions do not contact as the arms of the magnetic sensor are moved between open and closed configurations.

The first end of the second magnetic shield portion may include a cut-away to permit the first and second arms of the measurement device to move from the closed configuration to an open configuration, and the first and second magnetic shield portions may be shaped such that, when the first and second arms of the measurement device are in a closed configuration the first end of the first magnetic shield portion overlaps the cut-away of the second magnetic shield portion.

The first and second magnetic shield portions may be shaped so that, when the first and second arms of the measurement device are in a closed configuration, a second end of the first magnetic shield portion overlaps with a second end of the second magnetic shield portion.

When the first and second arms of the measurement device are in a closed configuration, the first and second magnetic shield portions may have a general axis of revolution, and a third diameter of the second end of the first magnetic shield portion relative to the general axis of revolution may be smaller than a fourth diameter of the second end of the second magnetic shield portion, such that, when the first and second arms of the measurement device are in a closed configuration the second end of the first magnetic shield portion is received within the second end of the second magnetic shield portion.

The third diameter of the second end of the first magnetic shield portion may be smaller than the first diameter of the first end of the first magnetic shield portion. The second diameter of the first end of the second magnetic shield portion may be smaller than the fourth diameter of the second end of the second magnetic shield portion. This ensures that the first magnetic shield portion can only be engaged with the second magnetic shield portion in a particular manner. Namely, the first end and the second end of the first magnetic shield portion must engage with the first end and the second end of the second magnetic shield portion, respectively. In this way, human errors in assembling the measurement device are prevented and the measurement device is therefore mistake-proofing.

The first magnetic core portion comprises separate first and second sectors, their being a non-magnetic clearance between a first end of the first sector and a first end of the second sector, and wherein the clearance between the first end of the first sector and a first end of the second sector is less than i) a clearance between the first end of the first sector and the first magnetic shield portion, and/or ii) a clearance between the first end of the second sector and the first magnetic shield portion, to thereby reduce flux leakage between the first magnetic core and the first magnetic shield portion. Minimising flux leakage from the core to the shield maximises magnetic flux flow through the core and hence to the sensor element, thereby improving the accuracy/sensitivity of the magnetic sensor.

The first magnetic shield portion may have a general axis of revolution, and a first diameter, relative to the general axis of revolution, of the first magnetic shield portion at a location adjacent the clearance between the first end of the first sector and a first end of the second sector may be greater than a second diameter, relative to the general axis of revolution, of the first magnetic shield portion at a location remote from the clearance between the first end of the first sector and a first end of the second sector. This bulging shape of the first magnetic shield portion aids the alignment of the first sector and the second sensor, and forces the first and second sectors together to keep the clearance between the first end of the first sector and the first end of the second sector constant, resulting in a uniform magnetic flux fringing field between the first and second sectors.

The first magnetic shield portion may comprise a first portion which substantially surrounds the first magnetic core portion at an outer circumference of the first magnetic core portion. The first portion may have a generally U-shaped cross section such that the first portion further substantially surrounds the first magnetic core portion on first and second opposite sides of the first magnetic core portion.

The first portion may be formed from a single piece of metal.

By making the first portion from a single piece of metal, it ensures that there is no gap within the first portion, thereby resulting in a consistently faultless shielding factor and an improved rejection of external magnetic fields. It further allows straightforward assembly of the first magnetic core portion and the first portion of the first magnetic shield portion, without the need of additional fixing means, such as, for example, tapes).

The first magnetic shield portion may further comprise a second portion which substantially surrounds the first magnetic core portion at an inner circumference of the first magnetic core portion. The second portion may be arranged to close an opening of the generally U-shaped first portion. By arranging the second portion to close the opening of the first portion, the magnetic flux within the first magnetic core portion is caused to be more homogeneous, thereby further improving positional sensitivity of the measurement device. In this way, the sensitivity of an output of the measurement device in response to a change of conductor positioning within the measurement device when in use can be reduced.

The first arm may further comprise an inner sheath which is configured to substantially house the first magnetic core portion. The inner sheath may be substantially contained within the first magnetic shield portion. The inner sheath may be configured such that there is a substantially constant gap between the first magnetic shield portion and the first magnetic core portion.

The inner sheath may be electrically insulating. As such, the inner sheath electrically isolates the first magnetic core portion from the first magnetic shield portion.

The first arm may further comprise an outer sheath which is configured to substantially house the first magnetic shield portion.

The first arm may further comprise at least one driving coil wrapped around the outer sheath. The at least one driving coil may also surround the first magnetic shield portion. Locating the drive coils such that they surround the first magnetic shield portion allows the device to be configured such that there is substantially zero flux within the magnetic core, and within the shield. Zero flux within the shield may act to reduce internal or external remanence effects which could be picked up by the sensor and thus lead to inaccurate current readings.

The outer sheath may be electrically insulating. As such, the outer sheath electrically isolates the at least one driving coil from the first magnetic shield portion. The outer sheath further provides safety creepage and clearance between the at least one driving coil and the first magnetic shield portion.

The first magnetic core portion may comprise a stack of core laminations. The design of the core laminations and the inner sheath may provide a straightforward method of core assembly, without the need for progressive stacking and specialist equipment, such as, for example, a clinching tool.

The inner sheath may comprise a first sheath section and a second sheath section. The first sheath section may be configured to substantially house the first sector of the first magnetic core portion. The second sheath section may be configured to substantially house the second sector of the first magnetic core portion. Each of the first and second sheath sections may comprise corresponding interlocking features. The interlocking features may be configured such that the first sector contacts the second sector via the first non-magnetic core discontinuity when the interlocking features of the first and second sheath sections are engaged. The interlocking feature may comprise at least one tooth and at least one recess.

The outer sheath may comprise a first sheath portion and a second sheath portion. The first sheath portion may substantially surround the first magnetic shield portion at an outer circumference of the first magnetic shield portion. The second sheath portion may substantially surround the first magnetic shield portion at an inner circumference of the first magnetic shield portion. The first sheath portion may overlap with the second sheath portion. The overlap may extend in a direction substantially parallel to the general axis of revolution of the first magnetic core portion.

By providing the interlocking features in the inner sheath, it provides a straightforward method of assembling the first magnetic core portion, without the need of additional fixing means, such as, for example, adhesives. The overlap of the first sheath portion and the second sheath section of the outer sheath further allows the outer sheath to be assembled around the first magnetic shield portion without the need of additional fixing means, such as, for example, adhesives.

The second arm may have features which are similar, or even identical, to those of the first arm. For example, the second arm may comprise at least one of a first portion and a second portion of the second magnetic shield portion, an inner sheath, an outer sheath and at least one driving coil, etc.. More generally, features described in the context of the first arm may be provided in combination with the second arm.

The measurement device may be a split-core fluxgate current sensing device, and the measurement device may comprise at least one fluxgate sensing element.

The first and second magnetic core portions may be separable and the first and second magnetic shield portions may be separable. As such, the core and shield may be referred to as a split core and a split shield, and the measurement device may be referred to as a split core measurement device.

Where appropriate any of the optional features described above in relation to one of the aspects of the present invention may be applied to another one of the aspects of the invention.

Features of the first aspect of the invention may be combined with features of the third aspect of the invention.

Specific embodiments of the present invention are described below, by way of example only, with reference to the accompanying drawings, in which:
Figure 1 is a side-on schematic part cut-away view of a split-core fluxgate current measurement device according to the present invention;
Figure 2 is an isometric view of a sector of a split-core fluxgate current measurement device according to the present invention;
Figure 3 is an enlarged isometric view of a sector, more definitively a part of a support member, of a split-core fluxgate current measurement device of the present invention;
Figure 4 is an enlarged isometric view of a portion of a split-core fluxgate current measurement device of the present invention;
Figure 5 is an isometric view of a portion of a split-core fluxgate current measurement device of the present invention;
Figure 6 is an isometric view of a portion of a split-core fluxgate current measurement device of the present invention;
Figure 7 shows an enlarged cross-sectional plan view of a portion of a split-core fluxgate current measurement device of the present invention.
Figure 8 is an isometric view of a portion of a split-core fluxgate current measurement device of the present invention;
Figure 9 is an enlarged schematic cross section of a portion of a split-core fluxgate current measurement device of the present invention;
Figure 10 is an isometric view of a portion of a split-core fluxgate current measuring device of the present invention;
Figure 11 is an isometric view of a portion of a split-core fluxgate current measurement device of the present invention;
Figure 12 is a side view of a split-core fluxgate current measuring device of the present invention in a closed configuration;
Figure 13 is a side view of a split-core fluxgate current measuring device of the present invention in an open configuration; and
Figure 14 is a perspective view of a split-core fluxgate current measuring device of the present invention in the open configuration.

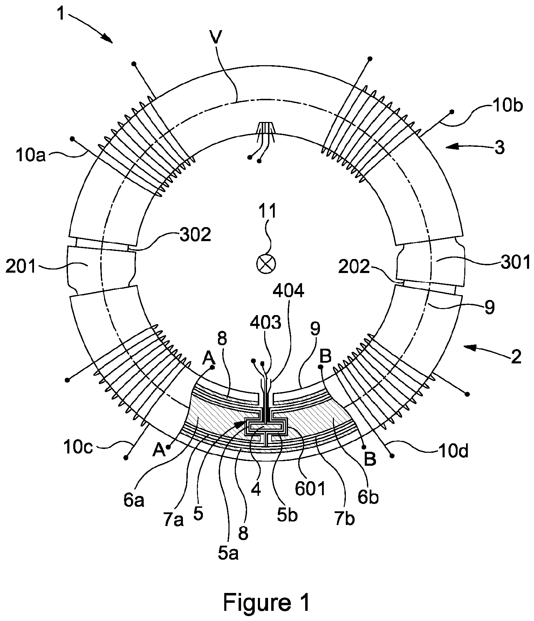

Figure 1 shows a side-on schematic view of a fluxgate measurement device according to the present invention. In particular, Figure 1 is a side-on schematic view of a split-core fluxgate current measurement device according to the present invention. The split-core fluxgate current measurement device 1 comprises first and second substantially identical arcuate arms 2 and 3. In other embodiments the first and second arms may have any other appropriate shape - for example they may have symmetrical or asymmetrical shape. The first and second arms 2 and 3 are movable relative to one another between an open configuration, in which the arms may be placed around a current carrying conductor 11, the current of which is desired to be sensed, and a closed configuration. In the closed configuration of the arms 2, 3, as shown in Figure 1, the two arms together form a generally toroidal or ring-shaped structure. The fact that the first and second arms (and, more particularly, core portions (discussed in more detail below) within the first and second arms) are movable between open and closed configurations means that the current measurement device may be referred to as a split-core current measurement device.

The features of the first arm 2 will now be described, however it will be appreciated that equivalent features to those described below are also present in the second, substantially identical, arm 3.

A portion of the first arm 2 is shown in cross sectional form between cut-away lines A-A and B-B. The first arm 2 comprises a fluxgate sensing element 4. The fluxgate sensing element 4 is contained within a support member 5 composed of first and second substantially identical support member portions 5a and 5b. The support member portions 5a, 5b are each located within an internal cavity 601 formed at the ends of substantially identical first and second magnetic core sectors 6a and 6b. In this manner the support member portions 5a, 5b support the fluxgate sensing element within the internal cavity 601. The internal cavity 601 is defined by both the first and second magnetic core sectors 6a and 6b. The first and second magnetic core sectors 6a, 6b are in turn housed within inner sheaths 7a and 7b. The inner sheaths 7a, 7b are contained within a shield 8 which is in turn housed within an outer sheath 9. The inner sheaths 7a, 7b ensures a substantially constant gap between the shield 8 and the magnetic core sectors 6a, 6b. Drive coils 10a-d are wrapped around the outer sheaths 9 of each of the arms 2 and 3.

The magnetic core sectors 6a, 6b of the first arm 2 form a first magnetic core portion and corresponding magnetic core sectors of the second arm 3 (not shown) form a second magnetic core portion. The first and second magnet core portions each define a respective internal cavity within which a respective fluxgate sensing element is contained. When the first and second arms 2, 3 are in the closed configuration, the first and second magnetic core portions are arranged to form a substantially complete inner magnetic circuit (or core) of a generally toroidal shape. It will further be appreciated that the fluxgate sensing elements 4 are located substantially within the general toroid formed by the magnetic circuit. As such, the inner magnetic circuit acts as a flux guide to channel flux through the fluxgate sensing elements 4 located within the cavity 601 formed by the magnetic core sectors 6a, 6b.

The assembly of the split-core fluxgate current sensing device 1 will now be described.

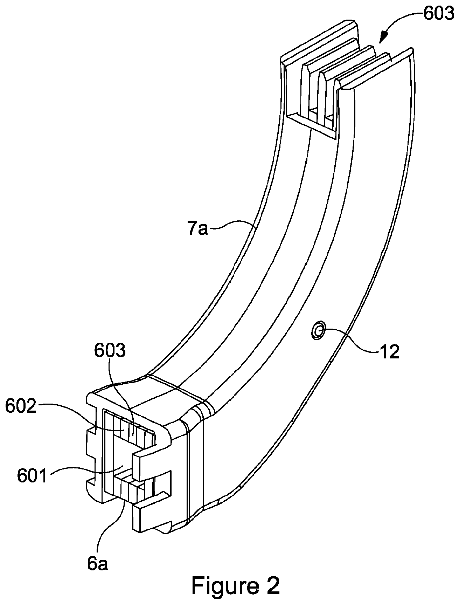

Figure 2 shows an isometric view of a portion of a split-core fluxgate current sensing device according to the present invention. In particular, Figure 2 shows the first magnetic core sector 6a housed within the inner sheath 7a. A pin 12 is inserted in an orifice of the inner sheath 7a to secure the first magnetic core sector 6a in place. In particular, the first magnetic core sector 6a comprises a stack of core sector laminations 603. The core sector laminations 603 are stacked in a direction which is generally parallel to a central rotational axis of the generally toroidal inner core. During manufacture, each of the laminations 603 is stacked and inserted into the inner sheath 7a. The pin 12 is inserted into the orifice in the inner sheath 7a and passes through corresponding orifices in each of the laminations 603 so as to hold each of the laminations in place within the inner sheath and to hold the laminations together to form the core sector 6a. Core sector 6b is formed in a similar manner. The design of the core laminations and inner sheath provides a relatively straightforward method of core assembly, without the need for progressive stacking and a clinching tool.

In the present embodiment the magnetic core sectors 6a and 6b are composed of nickel iron, however it will be appreciated that the magnetic core portions may be composed of any high magnetic permeability material, for example an amorphous ferromagnetic alloy. As previously discussed, the magnetic core portions of the present embodiment are formed as laminations (in this case of nickel iron); however it will be appreciated that the magnetic core portions may not have a laminated construction. The inner sheath 7a is composed of a thermoplastic such as, but not limited to, a polycarbonate material; however it will be appreciated that the inner sheath 7a may be composed of any other appropriate electrically insulating material such as ceramics. It will be appreciated that as the inner sheaths 7a, 7b are electrically insulating, there is no electrical conduction path between the magnetic core sectors 6a, 6b (i.e. core) and the shield 8.

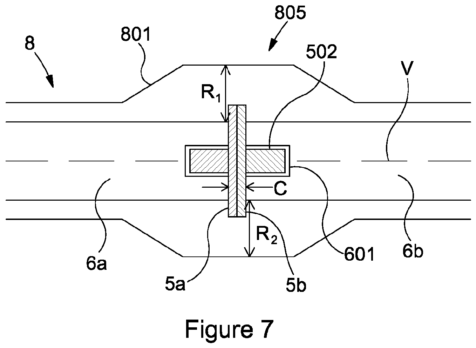

Each sector 6a, 6b is shaped such that they form an arcuate portion of the magnetic core. The internal cavity 601 is formed at an end face 602 of the first magnetic core sector 6a such that it extends from the end face 602 into the body of the first magnetic core sector 6a in a direction tangential to an axis of revolution (V, see Figures 1 and 7) of the arcuate portion (which is the same as the axis of revolution of the core). The generally toroidal core is defined by a surface of revolution generated by revolving a planar core cross-section about the generally circular axis of revolution (V), wherein the revolved cross-section is centred on the axis of revolution and the revolved cross section lies in a plane which remains generally perpendicular to the axis of revolution during the revolution about the axis of revolution.

The circular axis of revolution (V), as shown in Figures 1 and 7, may also be considered to be a path V which is generally circular in shape, and which is generally centred on a central rotational axis of the generally toroidal inner core (which central rotational axis is substantially perpendicular to the plane of the drawing of Figure 1, and which generally coincides with the location of the conductor 11 as shown in Figure 1). That is, the generally toroidal inner core (and sectors 6a, 6b thereof) has a cross section at each point along the path V (and substantially perpendicular thereto) which is generally constant. Moreover, the generally circular path V (the circular axis of revolution) has a generally constant radius about the central rotational axis.

Furthermore, the internal cavity 601 is formed at substantially the centre of the end face 602. An opposite end of the first magnetic core sector 6a to the first face 602 comprises laminations 603 which extend from the inner sheath 7a. The laminations 603 are arranged in a crenelated fashion, so as to allow them to be received by a corresponding oppositely crenelated magnetic core sector of the second arm 3 when the arms 2 and 3 are in the closed configuration. The crenelations may thus be considered to provide mating jaw tips. The mating jaw tips may reduce the errors in engaging the first and second arms 2 and 3, which may result in easier manufacture and reduced performance errors caused by temperature, misalignment and long term wear and tear. Such errors are commonly seen on measurement devices which use flat metal mating faces at the separation of the two arms. The shield (discussed in more detail below), in use, covers flux leakage between the crenelated portions when the arms are in the closed configuration.

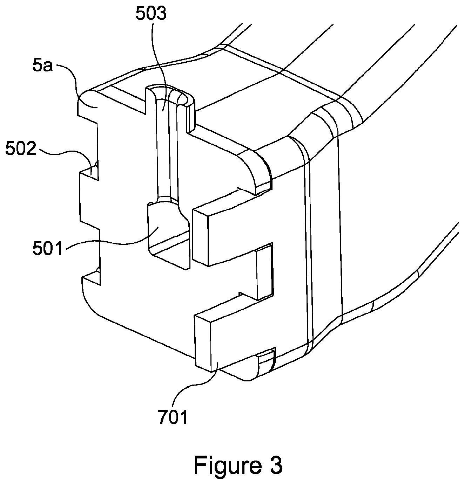

Figure 3 shows an enlarged isometric view of a portion of the split-core fluxgate current sensing device of the present invention. In particular, Figure 3 shows an enlarged view of an end of the assembly shown in Figure 2, into which the first support member portion 5a has been placed. The support member portion 5a further comprises a hollow boss portion 502 (see Figure 7) which is received within the internal cavity 601 of the first magnetic core sector 6a. The hollow boss portion forms an inner chamber 501 (or second internal cavity) defined by the support member portion 5a which is configured to receive the fluxgate sensing element 4. The support member portion 5a further comprises recesses 502 located along an edge of the support member which engage with corresponding teeth 701 of the inner sheath to locate the support member portion 5a. The support member portion 5a further comprises a recessed channel 503 which extends from the internal chamber 501 to an outer edge of the support member portion 5a. The support member portion 5a is composed of a thermoplastic, such as, but not limited to a polycarbonate material. However it will be appreciated that the support member may be composed of other electrically insulating materials such as ceramics. It will be appreciated that as the support member portions 5a, 5b are electrically insulating, an electrical conduction path between the magnetic core sectors 6a, 6b and the fluxgate sensing element 4 is substantially prevented.

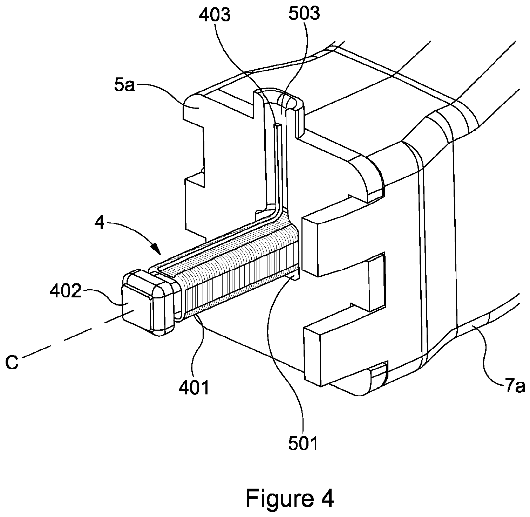

Figure 4 shows an enlarged isometric view of a portion of the split-core fluxgate current measurement device of the present invention. In particular, Figure 4 shows how the fluxgate 4 is located within the inner chamber 501 of the first support member portion 5a. The fluxgate 4 comprises a coil of wire 401 wound around a rod 402. Because the rod 402 is linear (i.e. extends along a generally straight line), the fluxgate 4 may be referred to as a linear fluxgate. A pair of wires 403 extend from each (or one) end of the coil 401 of the fluxgate sensing element 4 and up through the recessed channels 503 of the support member portions 5a, 5b. The wires 403 are fed away from the inner magnetic circuit and into a sensing circuit (not shown) of the current sensor of which the split-core fluxgate current measurement device 1 forms part. The current sensor is entirely conventional and, as such, the principles of its operation are not set out here as they will be well known by the person skilled in the art The coil is composed of enamel coated copper wire however it will be appreciated that the coil may be composed of any appropriate electrically conducting material. The rod 402 is composed of a thermoplastic, such as a polycarbonate material, or a ceramic; however, it will be appreciated that the rod may be composed of any high magnetic permeability material such as an amorphous magnetic material or a nanocrystalline magnetic material. The rod may further comprise an electrically insulating coating, such as Inlac (e.g. magnesium oxide coating).

As can be seen most clearly in Figure 1 the wires 403 are enclosed by a tube 404 of electrically insulating material which extends from the fluxgate sensing element up through the recessed channel 503 of the support member 5 and through apertures in the shield 8 and outer sheath 9. In the present embodiment the shield is formed from Teflon, however in other embodiments it may be formed from any appropriate electrically insulating material such as PTFE or glass.

It will be appreciated that the first support member portion 5a shown in Figure 4 forms one half of a support member assembly that is used to position the fluxgate 4 within the inner magnetic circuit. As such, the fluxgate sensing element 4 shown in Figure 4 is located all the way into the internal chamber 501 provided by the support member 5a, and is positioned such that substantially half of the fluxgate 4 protrudes from the internal recess 501. When assembled, the half of the fluxgate 4 that protrudes from the chamber 501 will be received by an equivalent internal recess of the second support member portion 5b. The internal chamber 501 of the support member portion 5a is located concentrically within the internal recess 601 of the first sector 6a. That is to say, when assembled, the internal chamber defined by the support members 5a, 5b, is concentric with the internal cavity 601 of the core.

As such, the fluxgate 4 is positioned substantially centrally within the cavity 601 defined by the first and second magnetic core sectors 6a, 6b. That is to say, substantially half of the fluxgate 4 is located in the portion of the cavity 601 defined by the first magnetic core sector 6a, and substantially half of the fluxgate 4 is located in the portion of the cavity 601 defined by the first magnetic core sector 6b. Furthermore, since the recesses 601 are provided at substantially the centre of the end faces 602 of the magnetic core sectors 6a, 6b it will be appreciated that a longitudinal axis C of the fluxgate sensing element 4 is substantially aligned with the axis of revolution V of the generally toroidal inner magnetic circuit formed by the magnetic core sectors. The fluxgate sensing element 4 is therefore supported by the support members portions 5a, 5b at substantially the centre of the join between the first and second magnetic core sectors 6a, 6b. It will be appreciated that positioning the fluxgate 4 in this manner has a desirable effect upon the sensitivity and accuracy of the split-core fluxgate current measurement device 1. In particular, the symmetry of the measurement device, whereby the fluxgate coils are supported by the support members such they have a substantially central position within the core results in the measurement device having reduced sensitivity to the position of the current conductor within the aperture defined by the core. That is to say, the measurement taken by the measurement device is substantially unaffected by the position of the current carrying conductor within the aperture defined by the core.

The first support member forms a first non-magnetic core discontinuity. The first fluxgate sensing element is contained within the first internal cavity such that at least a portion of the first fluxgate sensing element is located in the first non-magnetic core discontinuity. The first non-magnetic core discontinuity is said to be non-magnetic because it is a region having a relatively low magnetic permeability µ (compared to that of the core). In the present embodiment the core is formed from a material having relatively high magnetic permeability (nickel iron, a relative permeability µᵣ of about 70000 to about 150000) and the first non-magnetic core discontinuity is formed by the first support member which is made of polycarbonate having µ approximately equal to µ₀ (the permeability of free space). It will be appreciated that in some embodiments, the first non-magnetic core discontinuity may comprise air having µ approximately equal to µ₀. In other embodiments the first non-magnetic core discontinuity may comprise a region/material having a relatively low magnetic permeability of approximately µ₀. That is to say, in other embodiments the first non-magnetic core discontinuity may be formed in any appropriate manner, for example, but not limited to, an air-gap, a support member formed from any appropriate non-magnet material, or a separate member formed from any appropriate non-magnet material, the purpose of which is to create a non-magnetic core discontinuity. The first non-magnetic core discontinuity may comprise a region/material having a magnetic permeability which is less than that of the material which forms the first and/or second magnetic core portions.

The first non-magnetic core discontinuity is such that, when the first and second arms are in the closed configuration in order to form a substantially complete magnetic circuit which acts as a flux guide when the measurement device surrounds a current carrying conductor, the first non-magnetic core discontinuity acts as a gap or discontinuity in the core such that a fringing field is formed at the first non-magnetic core discontinuity. It follows that, when the measurement device surrounds a current carrying conductor, at least a portion of the first fluxgate sensing element is located in the fringing field formed at the first non-magnetic core discontinuity.

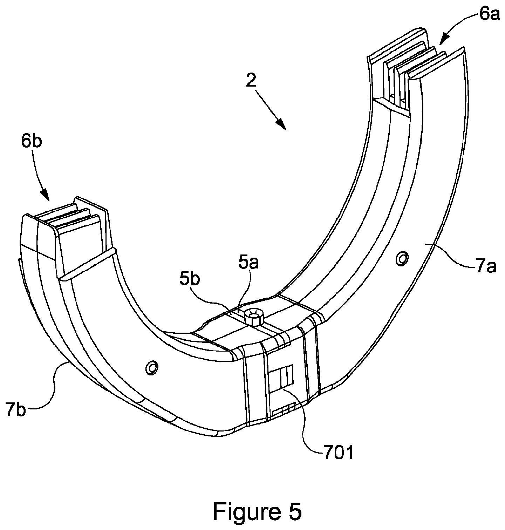

Figure 5 shows an isometric view of a portion of the split-core fluxgate current measurement device of the present invention. In particular, Figure 5 shows an inner assembly of the first arm 2. A first portion of the assembly comprises the first magnetic core sector 6a, the first inner sheath 7a and the first support member portion 5a. A corresponding second portion of the assembly comprises the second magnetic core sector 6b, the second inner sheath 7b and the second support member portion 5b. The first and second portions of the assembly contact one another via the first and second support member portions 5a, 5b and are located by the teeth 701 of the inner sheaths 7a, 7b.

During assembly, the fluxgate 4 is placed within the inner recess 501 of one of the support member portions 5a, 5b of the first or second sector of the assembly. The wires 403 (not shown in Figure 5) are fed through the insulating tube 404 and then the insulating tube 404 and wires 403 are fed along the recessed channel 503 away from the fluxgate sensing element 4. Subsequently the other of the first or second portions of the assembly is placed over the fluxgate sensing element 4 such that it is received by the corresponding internal cavity 501 of the other support member portion 5b. It will be appreciated that the inner cavities 501 of the support member portions 5a, 5b and the first and second magnetic core sectors 6a, 6b are substantially aligned when assembled in order to form the first inner chamber of the support members and the inner cavity of the core respectively. When assembled, the fluxgate sensing element 4 is located at substantially the centre of the inner cavity of the core. As such, the fluxgate sensing element 4 is contained within the inner (or internal) core cavity such that the fluxgate is enclosed by (or surrounded by) the core (formed by the first and second magnetic core sectors 6a, 6b) in three dimensions (i.e. three orthogonal dimensions of space). That is to say, the fluxgate sensing element 4 is surrounded by the magnetic core sectors 6a, 6b in a longitudinal direction (i.e. it is surrounded at its ends) and it is further surrounded by the magnetic core portions 6a, 6b in a plane orthogonal to the longitudinal direction (i.e. it is surrounded by its cross-sectional perimeter, where the cross section is perpendicular to the longitudinal axis). Put another way, the fluxgate sensing element is surrounded by the core such that one can place the origin of a Cartesian co-ordinate system at some point on the fluxgate sensing element and, in any orientation of the co-ordinate system, all three axes of the co-ordinate system will intersect with a portion of the core. It will further be appreciated that the fluxgate sensing element 4 is enclosed by (or surrounded by) the first and second support member portions 5a, 5b in a like manner. In this way, as previously discussed, because the first and second support member portions 5a, 5b are formed from an electrically insulating material, an unintended electrical path between the fluxgate sensing element and the core (and, in particular, the first magnetic core portion is substantially prevented.

The recessed channels 503 of each support member 5a, 5b are also substantially aligned such that the wires 403 of the fluxgate 4 (and surrounding tube 404) may pass from within the internal cavity 501 holding the fluxgate 4 to the sensing circuit (not shown).

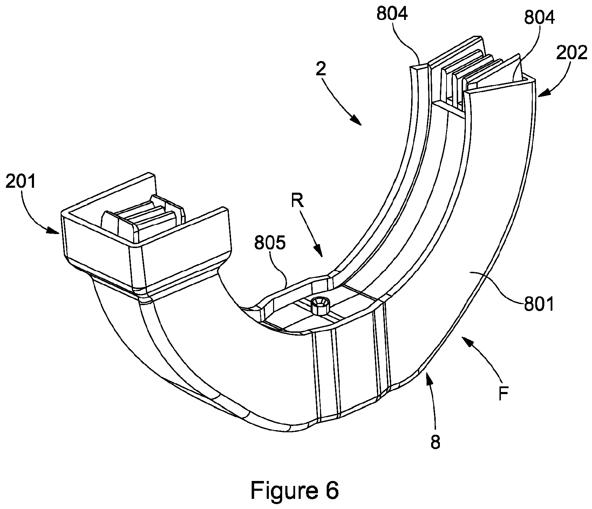

Figure 6 shows an isometric view of a portion of the split-core fluxgate current measurement device of the present invention. In particular, Figure 6 shows the inner assembly of the first arm 2 placed within a first portion 801 of the shield 8. The first portion 801 of the shield 8 is arcuate and is generally formed in a C-shape so that it substantially surrounds the inner assembly of the first arm 2 at the outer circumference of the inner assembly. The first portion 801 has a generally U-shaped cross section (when viewed in a plane orthogonal to the circumference of the inner assembly) so that it also substantially surrounds the inner assembly on both front and rear sides of the assembly, denoted by the arrows F and R respectively. The first portion 801 of the shield 8 comprises a female end 201 in which the U-shaped cross section has been widened and deepened so that it can receive a corresponding male portion 302 of the shield of the second arm 3 (not shown). The first portion 801 of the shield 8 further comprises a male end 202 having substantially the same cross section as the remainder of the first portion 801, and which is configured to be received by a corresponding female portion 301 of the second arm 3.

The male end 202 of the shield 8 further comprises a cut-away (or chamfer) 804 which is set at an angle which is inclined away from a radius of the first portion 801 at the point where the cut away meets the outer circumference of the first portion 801. That is to say, the cut-away 804 is inclined at an angle that is not normal to the circumference of the shield 8. It will be appreciated that such a cut away permits the first and second arms 2, 3 of the measurement device to move from the closed configuration to an open configuration without impacting upon the shield 8 of the other of the first and second arms 2, 3.

The first portion 801 is manufactured from a single piece of metal. The cross-sectional U shape of the first portion 801 may be made by bending the single piece of metal during the manufacturing process. By making the first portion 801 from a single piece of metal, it ensures that there is no gap within the first portion 801, thereby resulting in a consistently faultless shielding factor and an improved rejection of external magnetic fields.

During assembly, the inner assembly of the first arm 2 is directly placed within the U shape of the single-piece first portion 801. It does not require any use of additional fixing means in assembling the inner assembly and the first portion 801. In contrast, if the first portion 801 is made from separate metal pieces, additional fixing or support devices (for example, tapes) may be necessary in the assembly process. Therefore, manufacturing the first portion 801 from a single piece of metal greatly reduces the complexity in assembling the measurement device 1.

It will be appreciated that the internal cross-sectional size of the first portion 801 may be slightly larger than the external cross-sectional size of the inner assembly such that the inner assembly and the first portion 801 are engaged in a friction fit manner.

Figure 7 shows an enlarged cross-sectional plan view of a portion of the split-core fluxgate current measurement device of the present invention. In particular, Figure 7 shows a cross-section of the first arm 2 centred on the support portions 5a and 5b. It can be seen from the figure that the ends of the first and second magnetic core sectors 6a, 6b are separated by a clearance C due to the presence of the first and second support portions 5a, 5b. It will be appreciated that the clearance C is considered a non-magnetic clearance due to the absence of high magnetic permeability material in this region (i.e. because the support portions 5a, 5b are composed of thermoplastic, such as, but not limited to a polycarbonate material).

The shield 8 further comprises a widened portion 805 (or bulge). The purpose of this widened portion is to minimise the magnetic flux transmitted between the first and second magnetic core portions 6a, 6b from leaking into the shield 8. Magnetic flux which leaks from the magnetic core into the shield will have a diminished effect on the fluxgate sensing elements located in the core, thereby diminishing the accuracy and/or sensitivity of the sensor. As such, the clearances R1 and R2 defined between the end of each of the first and second magnetic core portions 6a, 6b and the widened portion 805 of the shield 8 are chosen to be greater than the clearance C between the first and second magnetic core portions. It will be appreciated that in this way, magnetic flux is encouraged to traverse the relatively short distance C between the first and second magnetic core sectors 6a, 6b to permeate the other of the magnetic core sectors, rather than traversing the greater distance R1, R2 to permeate the shield 8.

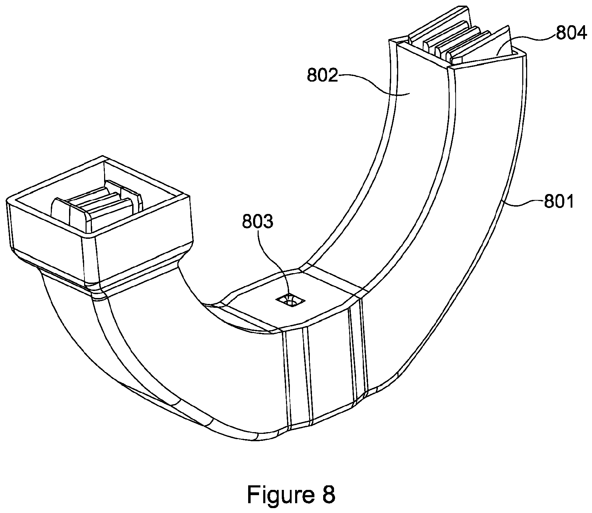

Figure 8 shows an isometric view of a portion of the split-core fluxgate current measurement device of the present invention. In particular, Figure 8 shows a second portion 802 of the shield 8 configured to be received by the first portion 801 such that the inner assembly of the first arm 2 is surrounded about its inner circumference. In particular, the second portion 802 is configured to be received by an open side of the first portion 801 formed by the generally U-shaped cross section. In this way, the second portion 802 effectively closes the top opening of the U shaped first portion 801. This results in more homogeneous magnetic flux within the magnetic core sectors 6a, 6b, thereby further improving positional sensitivity of the measurement device 1. The second portion 802 comprises an orifice 803 substantially aligned with the recesses 503 of the support member portions 5a, 5b. During assembly the wires 403 (not shown) and surrounding tube of the fluxgate sensing element 4 are first passed through the orifice 803 before the second portion 802 is assembled against the first portion 801. The first and second portions of the shield 8 are formed of a high permeability magnetic material such as nickel-iron; however it will be appreciated that the shield 8 may be formed of any high magnetic permeability material such as ferrite.

It will be appreciated that when the first and second substantially identical arms 2, 3 of the clamp measurement device 1 are assembled in the closed position (as shown in Figure 1) the shields 8 of both arms form a second, outer magnetic circuit which is separate to the inner magnetic circuit formed by the magnetic core sectors 6a and 6b. The second magnetic circuit is generally formed of a hollow toroid and therefore substantially surrounds (or encloses) the general toroid structure of the inner magnetic circuit. It will be appreciated that in so surrounding the first magnetic circuit, the second magnetic circuit acts as a flux guide to substantially minimise any external magnetic fields from entering the first magnetic circuit. Such external magnetic fields are any magnetic fields which are not produced by the current being sensed, and may be for example the magnetic field of the earth or local magnetic fields produced by other electrical currents present in the vicinity of the electrical current being sensed.

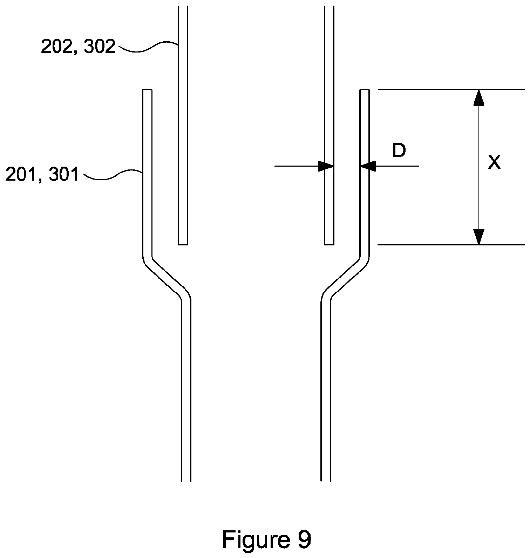

Figure 9 shows an enlarged schematic cross section of a portion of the split-core fluxgate current measurement device of the present invention. In particular, Figure 9 shows a cross sectional view of how the male portions 202, 302 of the shields 8 are received by the female portions 201, 301 of the shields 8 when the arms 2, 3 are in the closed configuration. The inner assembly has been omitted in order to aid the clarity of the figure. It can be seen from the figure that when the shields 8 are assembled in the closed position, an overlap X is created between the end of each male portion 202, 302 and the end of each female portion 201, 301. As previously discussed, the male portions 202, 302 of the shields 8 comprise the cut-away portions 804. The overlap X is chosen so that the cut-away portions 804 are also overlapped with the female portions 201, 301 such that the cut-away portions 804 are substantially surrounded by the female portions 202, 302 when the male portions 202, 302 are received by the female portions 201, 301.

Although not shown in Figure 8, it will be appreciated that the shields 8 are generally toroidal portions. As such, the overlap X is measured in a direction parallel to an axis of revolution defined by the generally toroidal portions. That is to say, to an observer viewing the clamp measurement device 1 when it is assembled in the closed configuration, there is no line of sight between the male portions 202, 302 and the female portions 201, 301 in a direction generally perpendicular to the axis of revolution of the shields 8. The overlap X of the present embodiment is typically 3mm - 5mm although the overlap X may be at least twice the spacing D (discussed in more detail below). It will be appreciated that this overlap helps to minimise the amount of external magnetic flux (i.e. flux which is not produced by the current to be measured) which may permeate the inner magnetic circuit (or core) formed by the magnetic core sectors 6a, 6b. As such, the overlap X helps to reduce interference caused by external magnetic fields which may affect the accuracy of the current measurement.

It can further be seen from Figure 9 that the male portions 202, 302 of the shield 8 and the female portions 201, 301 of the shield 8 are spaced apart from one another by a spacing D, measured in a direction substantially orthogonal to the direction of the overlap X. That is to say, the male portions 202, 302 define an outer diameter (perpendicular to the axis of revolution) and the female portions 201, 301 define an inner diameter (also perpendicular to the axis of revolution) that is larger than the outer diameter of the male portions 202, 302. The spacing D of the present embodiment is typically 1 - 2 mm although the spacing D is typically less than or equal to 0.5 X. This spacing D minimises the risk that any electrical current present in the shield 8 of the first or second arms 2, 3 is not transmitted to the shield 8 of the other of the first or second arms 2, 3. Such an electrical current may be present due to accidental electrical contact between the shield 8 and the current carrying conductor, the current of which is being measured, such as, for example, where the current carrying conductor is an exposed electrical bus bar. As such, the precise dimensions of the spacing D may be dependent upon the necessary shielding effectiveness.

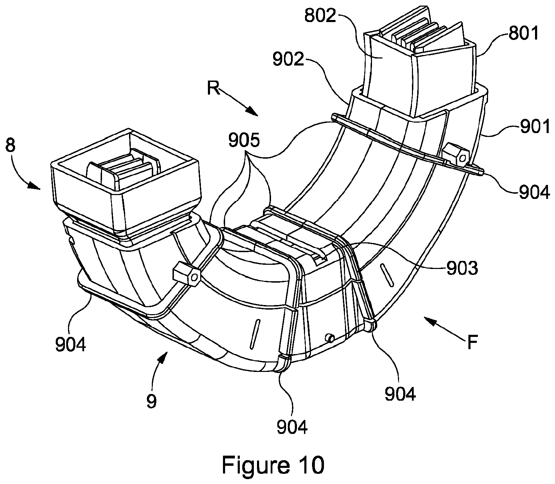

Figure 10 shows an isometric view of a portion of the split-core fluxgate current measurement device of the present invention. In particular, Figure 10 shows the outer sheath 9 assembled around the shield 8 of the first arm 2. The outer sheath 9 is formed of a first portion 901 and a second portion 902. The first portion 901 has an internal shape which corresponds to the outer shape of the first portion 801 of the shield 8. The first portion 901 surrounds the shield 8 about its front and rear sides (denoted by F and R respectively) and outer circumference. The second portion 902 surrounds the shield 8 about its inner circumference and further includes flanges which partially overlap with the first portion 901 to surround the shield 8 about its front and rear sides. During assembly, the first portion 901 is first placed around the outer circumference of the shield 8, the wires 403 and surrounding tube (not shown) are fed through a slot 903 of the second portion 902, and finally the second portion 902 is placed around the inner circumference of the shield 8 such that the first and second portions 901, 902 fit together to surround the shield 8. The wires 403 can then be fed to the sensing circuit (also not shown). The first and second portions 901, 902 further comprise outwardly extending flanges 904 and 905 respectively. The flanges 904 and 905 are substantially aligned with one another so as to from four continuous flanges around the perimeter of the outer sheath 9. These flanges extend radially outwards (relative to the revolution axis) from the first and second portions 901, 902.

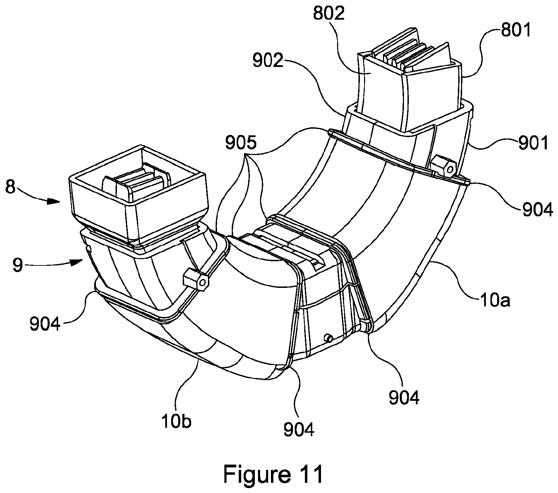

Figure 11 shows an isometric view of a portion of the split-core fluxgate current measurement device of the present invention. In particular Figure 11 shows the drive coils 10a and 10b assembled upon the outer sheath 9. The drive coils 10a, 10b are composed of enamelled copper wire and are assembled by winding the wire upon the outer sheath 9 between each of two pairs of the continuous flanges formed by flanges 904, 905, on pair being either side of the fluxgate sensing element 4 (not shown in Figure 11). The drive coils 10a, 10b therefore substantially surround the outer sheath 9, shield 8, inner sheaths 7a, 7b and magnetic core sectors 6a, 6b. The flanges 904, 905 act to locate and contain the drive coils upon the outer sheath 9. The drive coil wire is then fed into a drive circuit portion of the current sensor (not shown) which provides power to the drive coils 10a-d. It will be appreciated that by winding the drive coils 10a, 10b upon the outer sheath 9, separation of the first portion 901 and second portion 902 of the sheath 9 is prevented. As such the first arm 2 of the split-core fluxgate current measurement device 1 is fully assembled.

In the present embodiment the drive coils are linked to one another in series such that they can be considered to be a single coil. In other embodiments, there may be any appropriate electrical connection between the drive coils. For example, in some embodiments the drive coils may be linked in parallel. In other embodiments the drive coils may be driven individually.

The first and second portions 901, 902 of the outer sheath are composed of a thermoplastic, such as, but not limited to, a polycarbonate material, although it will be appreciated that the first and second portions 901, 902 may be composed of other electrically insulating materials such as a ceramic. It will further be appreciated that because the sheath 9 is composed of electrically insulating material, hazardous live voltages are substantially prevented from passing between the shield 8 and the drive coils 10a-d.

The drive coils are located such that they are angularly spaced from the ends of the shield portion of each arm and ends of the core portions of each arm. This minimises the chance of unwanted electrical potential transfer between a drive coil and each of the shield and core. Additionally, the drive coils are located such that the fluxgate sensing element 4 of each arm is centrally located between the two drive coils of that arm.

Locating the drive coils such that they surround the shield ensures zero flux within both the core and within the shield. Zero flux within the shield ensures no internal or external remanent effects which could be picked up by the fluxgate and thus lead to inaccurate current readings.

A second electrical isolation (safety creepage and clearance) is achieved via the outer sheath (in addition to the tube surrounding the fluxgate wires and the inner sheath). This electrical isolation separates the shield from any of the fluxgate winding, the core and the drive coils. Both the first and second isolations act so as to isolate primary parts of the measurement device circuit (core and shield) from secondary parts of the measurement device circuit (fluxgate, drive coils and connections thereto). Isolating the primary and secondary parts of the measurement device circuit minimises the risk that, if the measurement device comes into contact with a current carrying conductor, hazardous live voltages from the current carrying conductor is transmitted to a user of the measurement device, thereby endangering the safety of the user.

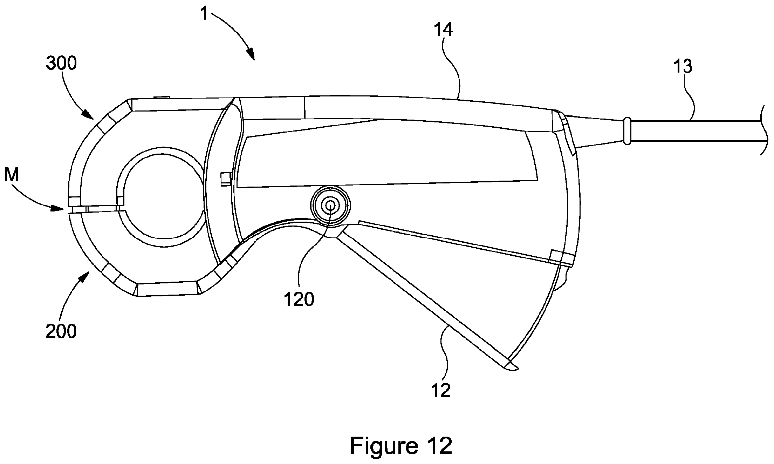

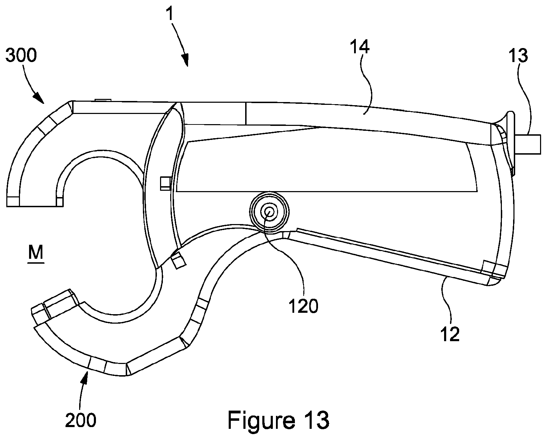

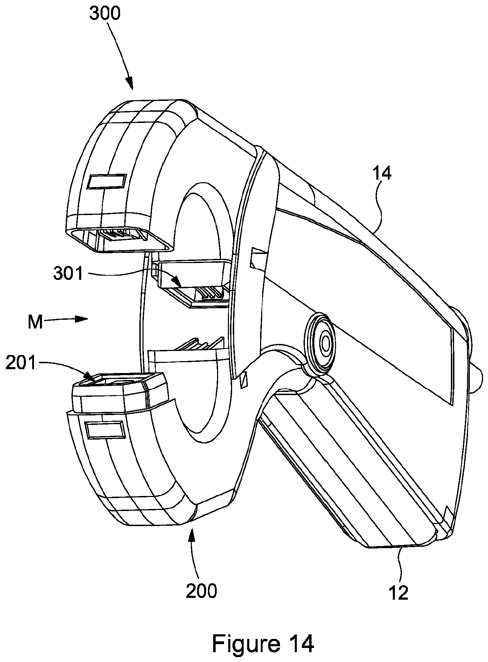

Figures 12 and 13 show side views of a split-core fluxgate current measurement device according to one embodiment of the present invention. Figure 14 shows a perspective view of the same split-core fluxgate current measurement device. The split-core fluxgate current measurement device 1 comprises a clamp body including a body portion 14, a handle 12, a first jaw 200, and a second jaw 300. A measurement device which includes an actuator (such as, in this case, handle 12) to move the measurement device between open and closed configurations (discussed further below) may be referred to as a probe. A probe which is biased into the closed configuration (again, discussed further below) may be referred to as a clamp probe. The first jaw 200 houses the first arm 2 (not shown) whilst the second jaw 300 houses the second arm 3 (not shown). The jaws 200, 300 are formed of a thermoplastic material, such as, but not limited to polycarbonate. However, it will be appreciated that the jaws may be formed of any other appropriate electrically insulating material. It will further be appreciated that because the jaws are electrically insulating, users of the clamp probe are substantially insulated from the hazardous live voltages on the primary current carrying conductor and are also isolated from the drive coils 10a-d (not shown).

The first jaw 200 is formed as one piece with the handle 12 and is rotatable relative to the second jaw 300 about a pivot 120. The second jaw 300 is formed as once piece with the body 14. The clamp probe 1 is configured such that the first jaw is biased by a resilient biasing member (such as, but not limited to, a spring - not shown) relative to the second jaw into a closed configuration as shown in Figure 12. Put another way, the biasing member (not shown) may be configured to urge the handle 12 away from the body 14 so as to ensure that the jaws 200, 300 return to the closed configuration when not acted upon by a user. In the closed configuration of the first and second jaws, the probe is in the closed configuration as referred to earlier within this document. The clamp probe 1 is designed so that during use a user squeezes the handle 12 against the body 11 in one hand to overcome the resilient biasing member so as to cause the first jaw 200 to rotate about the pivot 120 and thus separate from the second jaw 300 so as to arrive at an open configuration as shown in Figures 13 and 14. As such, a gap or mouth M is formed between the two jaws which allows the user to place the clamp probe 1 around a current carrying conductor, the current flow through which is to be measured. It will be appreciated that in this relative position of the first and second jaws, the probe may be said to be in the open configuration as discussed earlier within this document. The user then releases their grip to allow the jaws to return to the closed configuration (as shown in Figure 12) so that the inner and outer magnetic circuits completely surround the current carrying conductor 11.

The clamp probe 1 further comprises a cord 13. In some embodiments the cord contains the wiring mentioned above which links the fluxgate coils to the sensing circuit of the sensor and the wiring which links the drive coils to the drive circuit of the sensor. In other embodiments the cord may contain wiring which connects a power supply of the sensor to the drive coil(s) of the measurement device, and which supplies an output signal from electronic circuitry within the measurement device to the sensor. In some embodiments the measurement device may include relevant circuitry and/or processing to convert the power supplied to the drive coils (and flux measured by the fluxgate coils) into a signal which is indicative of the current flowing through the current carrying conductor. In other embodiments the circuitry and/or processing to convert the power supplied to the drive coils (and flux measured by the fluxgate coils) into a signal which is indicative of the current flowing through the current carrying conductor may form part of the portion of the sensor which is connected to the measurement device by the cord.

The first and second jaws substantially surround the first and second arms 2, 3 in order to shield the arms from the user. However, it will be appreciated that when the jaws 200, 300 are in the closed position, as shown in Figure 12, the magnetic core sectors 6a, 6b of the arms 2, 3 are aligned to form the inner magnetic circuit (core) and the shield portions 8 are aligned to form the outer magnetic circuit (shield).

It will be appreciated that the drive coils 10a-d may be connected in series and/or may be driven by the drive circuit. It will further be appreciated that the fluxgate sensing elements 4 may be connected in in parallel. In one embodiment the fluxgate coils are connected in series. The operation of the drive and sensing circuitry of the sensor is well known in the art and is therefore not discussed in any detail.

It will be appreciated that the support member portions 5a, 5b, inner sheaths 7a, 7b, outer sheath 9, tubing 404 which surrounds the fluxgate sensing element wires, handle portion 12 and body portion 14 are composed of electrically insulating materials. As such, these materials ensure electrical isolation between the electrically conductive components of the fluxgate clamp measurement device 1, such as the fluxgate sensing elements 4, the magnetic core sectors 6a, 6b, shield 8 and the drive coils 10a-d. The electrical isolation between electrically conductive components encompasses clearances between components of the measurement device sufficient to prevent arcing between those components - such clearances are enhanced by placing electrically insulating components between conductive components. Furthermore, such electrical isolation also encompasses increasing creepage distances - i.e. the distance along the surfaces of electrically insulating components between two electrical conductors - to reduce the creepage of charge between two such electrical conductors along the surfaces of electrically insulating components there between. When a measurement device includes a way of moving the measurement device between open and closed configurations, such as, for example, the handle discussed above, the measurement device may be referred to as a probe or a probe transducer.

It will be appreciated that various modifications to the embodiments of the invention discussed above, without departing from the scope of the invention as defined by the claims, will be apparent to the person skilled in the art. Examples of such modifications are given below.

The fluxgate sensing elements discussed above are linear fluxgate sensing elements. It will be appreciated that in other embodiments any appropriate geometry of fluxgate sensing element may be used.

Various features of the described embodiments are described as being generally toroidal, such as, for example, the magnetic circuits in the form of the core and the shield. These generally toroidal features are defined by surfaces of revolution about a generally circular axis of revolution. In other embodiments, the magnetic circuits may have any appropriate form/shape. For example, the general axis of revolution may have any appropriate shape - it may be generally elliptical or a quadrilateral. In such embodiments, it will be appreciated that the shape of the other components within the measurement device, for example the inner and outer sheaths, will correspond to that of the magnetic circuits.

In the above described embodiments the two halves (i.e. arms) of the measurement devices are substantially identical. In other embodiments this need not be the case provided the measurement device is still capable of performing its purpose.

The clamp body shown in Figures 12, 13 and 14 is only a single example of a possible clamp body including first and second arms according to the present invention. It will be appreciated that the present invention applies to any type of clamp body provided it includes first and second arms having the features of the present invention.

## Claims

1. A split-core current measurement device (1) comprising:
a first arm (2) including a first magnetic core portion (6a, 6b);
a second arm (3) including a second magnetic core portion;
a first sensing element (4) sensitive to changes in magnetic field;
the first and second magnetic core portions being shaped so that, when the first and second arms of the measurement device are in a closed configuration, the first and second magnetic core portions cooperate to form a substantially complete magnetic circuit configured to act as a flux guide when the measurement device surrounds a current carrying conductor (11); wherein the first magnetic core portion includes a first non-magnetic core discontinuity; and
wherein
the first magnetic core portion defines a first internal cavity (501) within which the first sensing element (4) is contained such that at least a portion of the first sensing element is located in the first non-magnetic core discontinuity,
the first magnetic core portion comprises separate first and second sectors (6a, 6b), wherein a first end of the first sector (6a) and a first end of the second sector (6b) are separated by a non-magnetic clearance (C) due to the presence of the first non-magnetic core discontinuity, and **characterised in that**
the clearance (C) between the first end of the first sector and the first end of the second sector is less than i) a clearance (R1) between the first end of the first sector (6a) and a first magnetic shield portion (801) of the first arm, and/or ii) a clearance (R2) between the first end of the second sector (6b) and the first magnetic shield portion (801), to thereby reduce flux leakage between the first magnetic core portion and the first magnetic shield portion.

2. A measurement device according to claim 1, wherein the first sensing element (4) is contained within the first internal cavity (501) such that the first magnetic core portion (6a, 6b) encloses the first sensing element in three dimensions.

3. A measurement device according to claim 1 or 2, wherein the first internal cavity (501) is defined by both the first sector (6a) and the second sector (6b).

4. A measurement device according to any preceding claim, further comprising a first support member (5), the first support member supporting the first sensing element (4) within the first internal cavity (501).

5. A measurement device according to claim 4, wherein the first magnetic core portion (6a, 6b) has a general axis of revolution (V), wherein the first internal cavity (501) lies on the general axis of revolution (V), wherein the first sensing element has a longitudinal axis, and wherein the first support member is configured to support the first sensing element within the first internal cavity such that the first sensing element is centralised within the first magnetic core portion whereby the longitudinal axis of the sensing element lies on the general axis of revolution (V) of the first magnetic core portion.

6. A measurement device according to either claim 4 or claim 5, wherein the support member (5) is formed from an electrically insulating material.

7. A measurement device according to claim 6, wherein the first support member (5) encloses the first sensing element (4) in three dimensions such that an unintended electrical path between the first sensing element (4) and the first magnetic core portion (6a, 6b) is substantially prevented.

8. A measurement device according to any one of claims 4 to 7, wherein the first support member (5) is formed at least in part from a non-magnetic material.

9. A measurement device according to any one of claims 4 to 8, wherein the first support member (5) forms at least part of the first non-magnetic core discontinuity.

10. A measurement device according to any preceding claim, wherein:
the second arm (3) includes a second magnetic shield portion; and
the first and second magnetic shield portions are shaped so that, when the first and second arms (2, 3) of the measurement device are in a closed configuration, a first end (201) of the first magnetic shield portion overlaps with a first end (302) of the second magnetic shield portion and the first and second magnetic shield portions cooperate to form a second substantially complete magnetic circuit which encloses the first and second magnetic core portions and is configured to act as a magnetic shield which acts, when the measurement device surrounds a current carrying conductor (11), to minimise flux other than the flux of the current carrying conductor from passing through the first and second magnetic core portions.

11. A measurement device according to claim 10, wherein, when the first and second arms of the measurement device are in a closed configuration, the first and second magnetic shield portions have a general axis of revolution (V) and wherein the first end (201) of the first magnetic shield portion overlaps with the first end (302) of the second magnetic shield portion in a direction parallel to the general axis of revolution at the first end of the first magnetic shield portion and at the first end of the second magnetic shield portion.

12. A measurement device according to claim 10 or 11, wherein when the first and second arms of the measurement device are in a closed configuration, the first and second magnetic shield portions have a general axis of revolution, and wherein a first diameter of the first end (201) of the first magnetic shield portion relative to the general axis of revolution is greater than a second diameter of the first end (302) of the second magnetic shield portion, such that, when the first and second arms of the measurement device are in a closed configuration the first end of the second magnetic shield portion is received within the first end of the first magnetic shield portion.

13. A measurement device according to any one of claims 10 to 12 wherein the first end of the second magnetic shield portion includes a cut-away (804) to permit the first and second arms of the measurement device to move from the closed configuration to an open configuration, and wherein the first and second magnetic shield portions are shaped such that, when the first and second arms of the measurement device are in a closed configuration the first end of the first magnetic shield portion overlaps the cut-away of the second magnetic shield portion.

14. A measurement device according to any one of claims 10 to 13, wherein the first magnetic shield portion has a general axis of revolution (V), and wherein a first diameter, relative to the general axis of revolution, of the first magnetic shield portion (801, 802) at a location adjacent the clearance (C) between the first end of the first sector and the first end of the second sector is greater than a second diameter, relative to the general axis of revolution, of the first magnetic shield portion (801, 802) at a location remote from the clearance (C) between the first end of the first sector and the first end of the second sector.

15. A measurement device according to any one of claims 1 to 14, wherein the measurement device is a split-core fluxgate current measurement device, and wherein the first sensing element comprises a fluxgate sensing element.

## Patentansprüche

1. Strommessvorrichtung (1) mit geteiltem Kern, die Folgendes umfasst:
einen ersten Arm (2), der einen ersten magnetischen Kernabschnitt (6a, 6b) einschließt,
einen zweiten Arm (3), der einen zweiten magnetischen Kernabschnitt einschließt,
ein erstes Sensorelement (4), das für Änderungen bei einem Magnetfeld empfindlich ist,
wobei der erste und der zweite magnetische Kernabschnitt so geformt sind, dass, wenn sich der erste und der zweite Arm der Messvorrichtung in einer geschlossenen Konfiguration befinden, der erste und der zweite magnetische Kernabschnitt zusammenwirken, um einen im Wesentlichen vollständigen magnetischen Kreis zu bilden, der dafür konfiguriert ist, als ein Flusspfad zu wirken, wenn die Messvorrichtung einen Strom führenden Leiter (11) umschließt, wobei der erste magnetische Kernabschnitt eine erste nichtmagnetische Kernunterbrechung einschließt, und
wobei
der erste magnetische Kernabschnitt einen ersten inneren Hohlraum (501) definiert, innerhalb dessen das erste Sensorelement (4) derart enthalten ist, dass mindestens ein Abschnitt des ersten Sensorelements in der ersten nichtmagnetischen Kernunterbrechung angeordnet ist,
der erste magnetische Kernabschnitt gesonderte erste und zweite Sektoren (6a, 6b) umfasst, wobei ein erstes Ende des ersten Sektors (6a) und ein erstes Ende des zweiten Sektors (6b) auf Grund des Vorhandenseins der ersten nichtmagnetischen Kernunterbrechung durch einen nichtmagnetischen Zwischenraum (C) getrennt sind, und **dadurch gekennzeichnet, dass**
der Zwischenraum (C) zwischen dem ersten Ende des ersten Sektors und dem ersten Ende des zweiten Sektors geringer ist als i) ein Zwischenraum (R1) zwischen dem ersten Ende des ersten Sektors (6a) und einem ersten magnetischen Abschirmungsabschnitt (801) des ersten Arms und/oder ii) ein Zwischenraum (R2) zwischen dem ersten Ende des zweiten Sektors (6b) und dem ersten magnetischen Abschirmungsabschnitt (801), um dadurch einen Streufluss zwischen dem ersten magnetischen Kernabschnitt und dem ersten magnetischen Abschirmungsabschnitt zu verringern.

2. Messvorrichtung nach Anspruch 1, wobei das erste Sensorelement (4) derart innerhalb des ersten inneren Hohlraums (501) enthalten ist, dass der erste magnetische Kernabschnitt (6a, 6b) das erste Sensorelement in drei Dimensionen umschließt.

3. Messvorrichtung nach Anspruch 1 oder 2, wobei der erste innere Hohlraum (501) durch sowohl den ersten Sektor (6a) als auch den zweiten Sektor (6b) definiert wird.

4. Messvorrichtung nach einem der vorhergehenden Ansprüche, der ferner ein erstes Stützelement (5) umfasst, wobei das erste Stützelement das erste Sensorelement (4) innerhalb des ersten inneren Hohlraums (501) stützt.

5. Messvorrichtung nach Anspruch 4, wobei der erste magnetische Kernabschnitt (6a, 6b) eine allgemeine Umdrehungsachse (V) aufweist, wobei der erste innere Hohlraum (501) auf der allgemeinen Umdrehungsachse (V) liegt, wobei das erste Sensorelement eine Längsachse aufweist und wobei das erste Stützelement dafür konfiguriert ist, das erste Sensorelement derart innerhalb des ersten inneren Hohlraums zu stützen, dass das erste Sensorelement innerhalb des ersten magnetischen Kernabschnitts zentriert ist, wodurch die Längsachse des Sensorelements auf der allgemeinen Umdrehungsachse (V) des ersten magnetischen Kernabschnitts liegt.

6. Messvorrichtung nach entweder Anspruch 4 oder Anspruch 5, wobei das Stützelement (5) aus einem elektrisch isolierenden Werkstoff geformt ist.

7. Messvorrichtung nach Anspruch 6, wobei das erste Stützelement (5) das erste Sensorelement (4) derart in drei Dimensionen umschließt, dass ein unbeabsichtigter Stromweg zwischen dem ersten Sensorelement (4) und dem ersten magnetischen Kernabschnitt (6a, 6b) im Wesentlichen verhindert wird.

8. Messvorrichtung nach einem der Ansprüche 4 bis 7, wobei das erste Stützelement (5) mindestens zum Teil aus einem nichtmagnetischen Werkstoff geformt ist.

9. Messvorrichtung nach einem der Ansprüche 4 bis 8, wobei das erste Stützelement (5) mindestens einen Teil der ersten nichtmagnetischen Kernunterbrechung bildet.

10. Messvorrichtung nach einem der vorhergehenden Ansprüche, wobei:
der zweite Arm (3) einen zweiten magnetischen Abschirmungsabschnitt einschließt und
der erste und der zweite magnetische Abschirmungsabschnitt so geformt sind, dass, wenn sich der erste und der zweite Arm (2, 3) der Messvorrichtung in einer geschlossenen Konfiguration befinden, sich ein erstes Ende (201) des ersten magnetischen Abschirmungsabschnitts mit einem ersten Ende (302) des zweiten magnetischen Abschirmungsabschnitts überlappt und der erste und der zweite magnetische Abschirmungsabschnitt zusammenwirken, um einen zweiten im Wesentlichen vollständigen magnetischen Kreis zu bilden, der den ersten und den zweiten magnetischen Kernabschnitt umschließt und dafür konfiguriert ist, als eine magnetische Abschirmung zu wirken, die wirkt, um wenn die Messvorrichtung einen Strom führenden Leiter (11) umschließt, einen anderen Fluss als den Fluss des Strom führenden Leiters vom Hindurchgehen durch den ersten und den zweiten magnetischen Kernabschnitt zu minimieren.

11. Messvorrichtung nach Anspruch 10, wobei, wenn sich der erste und der zweite Arm der Messvorrichtung in einer geschlossenen Konfiguration befinden, der erste und der zweite magnetische Abschirmungsabschnitt eine allgemeine Umdrehungsachse (V) aufweisen und wobei sich das erste Ende (201) des ersten magnetischen Abschirmungsabschnitts mit dem ersten Ende (302) des zweiten magnetischen Abschirmungsabschnitts in einer Richtung, die parallel zu der allgemeinen Umdrehungsachse ist, an dem ersten Ende des ersten magnetischen Abschirmungsabschnitts und an dem ersten Ende des zweiten magnetischen Abschirmungsabschnitts überlappt.

12. Messvorrichtung nach Anspruch 10 oder 11, wobei, wenn sich der erste und der zweite Arm der Messvorrichtung in einer geschlossenen Konfiguration befinden, der erste und der zweite magnetische Abschirmungsabschnitt eine allgemeine Umdrehungsachse aufweisen und wobei ein erster Durchmesser des ersten Endes (201) des ersten magnetischen Abschirmungsabschnitts im Verhältnis zu der allgemeinen Umdrehungsachse größer ist als ein zweiter Durchmesser des ersten Endes (302) des zweiten magnetischen Abschirmungsabschnitts, so dass, wenn sich der erste und der zweite Arm der Messvorrichtung in einer geschlossenen Konfiguration befinden, das erste Ende des zweiten magnetischen Abschirmungsabschnitts innerhalb des ersten Endes des ersten magnetischen Abschirmungsabschnitts aufgenommen wird.

13. Messvorrichtung nach einem der Ansprüche 10 bis 12, wobei das erste Ende des zweiten magnetischen Abschirmungsabschnitts einen Ausschnitt (804) einschließt, um zu ermöglichen, dass sich der erste und der zweite Arm der Messvorrichtung von der geschlossenen Konfiguration zu einer offenen Konfiguration bewegen, und wobei der erste und der zweite magnetische Abschirmungsabschnitt derart geformt sind, dass, wenn sich der erste und der zweite Arm der Messvorrichtung in einer geschlossenen Konfiguration befinden, das erste Ende des ersten magnetischen Abschirmungsabschnitts den Ausschnitt des zweiten magnetischen Abschirmungsabschnitts überlappt.

14. Messvorrichtung nach einem der Ansprüche 10 bis 13, wobei der erste magnetische Abschirmungsabschnitt eine allgemeine Umdrehungsachse (V) aufweist und wobei ein erster Durchmesser, im Verhältnis zu der allgemeinen Umdrehungsachse, des ersten magnetischen Abschirmungsabschnitts (801, 802) an einer Position, die angrenzend an den Zwischenraum (C) zwischen dem ersten Ende des ersten Sektors und dem ersten Ende des zweiten Sektors ist, größer ist als ein zweiter Durchmesser, im Verhältnis zu der allgemeinen Umdrehungsachse, des ersten magnetischen Abschirmungsabschnitts (801, 802) an einer Position, die entfernt von dem Zwischenraum (C) zwischen dem ersten Ende des ersten Sektors und dem ersten Ende des zweiten Sektors ist.

15. Messvorrichtung nach einem der Ansprüche 1 bis 14, wobei die Messvorrichtung eine Fluxgate-Strommessvorrichtung mit geteiltem Kern ist und wobei das erste Sensorelement ein Fluxgate-Sensorelement umfasst.

## Revendications

1. Dispositif de mesure de courant à noyau divisé (1) comprenant :
un premier bras (2) incluant une première partie de noyau magnétique (6a, 6b),
un deuxième bras (3) incluant une deuxième partie de noyau magnétique,
un premier élément de détection (4) sensible aux variations de champ magnétique,
les première et deuxième parties de noyau magnétique étant formées de telle manière que, lorsque les premier et deuxième bras du dispositif de mesure sont dans une configuration fermée, les première et deuxième parties de noyau magnétique coopèrent pour former un circuit magnétique sensiblement complet configuré pour servir de guide de flux lorsque le dispositif de mesure entoure un conducteur de courant (11), dans lequel la première partie de noyau magnétique inclut une première discontinuité non magnétique du noyau, et
dans lequel
la première partie de noyau magnétique définit une première cavité interne (501) dans laquelle le premier élément de détection (4) est logé de telle manière qu'au moins une partie du premier élément de détection est située dans la première discontinuité non magnétique du noyau,
la première partie de noyau magnétique comprend des premier et deuxième secteurs séparés (6a, 6b), dans lequel une première extrémité du premier secteur (6a) et une première extrémité du deuxième secteur (6b) sont séparées par un espace libre (C) non magnétique due à la présence de la première discontinuité non magnétique du noyau, et **caractérisé en ce que**
l'espace libre (C) entre la première extrémité du premier secteur et la première extrémité du deuxième secteur est inférieur à i) un espace libre (R1) entre la première extrémité du premier secteur (6a) et une première partie d'écran magnétique (801) du premier bras, et/ou ii) un espace libre (R2) entre la première extrémité du deuxième secteur (6b) et la première partie d'écran magnétique (801), afin de réduire ainsi une perte de flux entre la première partie de noyau magnétique et la première partie d'écran magnétique.

2. Dispositif de mesure selon la revendication 1, dans lequel le premier élément de détection (4) est logé à l'intérieur de la première cavité interne (501) de telle manière que la première partie de noyau magnétique (6a, 6b) enferme le premier élément de détection dans trois dimensions.

3. Dispositif de mesure selon la revendication 1 ou 2, dans lequel la première cavité interne (501) est définie à la fois par le premier secteur (6a) et le deuxième secteur (6b).

4. Dispositif de mesure selon l'une quelconque des revendications précédentes, comprenant en outre un premier élément de support (5), le premier élément de support supportant le premier élément de détection (4) à l'intérieur de la première cavité interne (501).

5. Dispositif de mesure selon la revendication 4, dans lequel la première partie de noyau magnétique (6a, 6b) présente un axe général de révolution (V), dans lequel la première cavité interne (501) est située sur l'axe général de révolution (V), dans lequel le premier élément de détection présente un axe longitudinal, et dans lequel le premier élément de support est configuré pour supporter le premier élément de détection à l'intérieur de la première cavité interne de manière à ce que le premier élément de détection soit centré à l'intérieur de la première partie de noyau magnétique, au moyen de quoi l'axe longitudinal de l'élément de détection est situé sur l'axe général de révolution (V) de la première partie de noyau magnétique.

6. Dispositif de mesure selon la revendication 4 ou 5, dans lequel l'élément de support (5) est formé d'un matériau électriquement isolant.

7. Dispositif de mesure selon la revendication 6, dans lequel le premier élément de support (5) enferme le premier élément de détection (4) dans trois dimensions de manière à empêcher sensiblement un trajet électrique involontaire entre le premier élément de détection (4) et la première partie de noyau magnétique (6a, 6b).

8. Dispositif de mesure selon l'une quelconque des revendications 4 à 7, dans lequel le premier élément de support (5) est formé au moins en partie d'un matériau non magnétique.

9. Dispositif de mesure selon l'une quelconque des revendications 4 à 8, dans lequel le premier élément de support (5) forme au moins une partie de la première discontinuité non magnétique du noyau.

10. Dispositif de mesure selon l'une quelconque des revendications précédentes, dans lequel :
le deuxième bras (3) inclut une deuxième partie d'écran magnétique, et
les première et deuxième parties d'écran magnétique sont formées de telle manière que, lorsque les premier et deuxième bras (2, 3) du dispositif de mesure sont dans une configuration fermée, une première extrémité (201) de la première partie d'écran magnétique chevauche une première extrémité (302) de la deuxième partie d'écran magnétique et les première et deuxième parties d'écran magnétique coopèrent pour former un deuxième circuit magnétique sensiblement complet qui enferme les première et deuxième parties de noyau magnétique et est configuré pour servir d'écran magnétique qui agit, lorsque le dispositif de mesure entoure un conducteur de courant (11), pour minimiser le passage d'un flux autre que le flux du conducteur de courant à travers les première et deuxième parties de noyau magnétique.

11. Dispositif de mesure selon la revendication 10, dans lequel, lorsque les premier et deuxième bras du dispositif de mesure sont dans une configuration fermée, les première et deuxième parties d'écran magnétique présentent un axe général de révolution (V) et dans lequel la première extrémité (201) de la première partie d'écran magnétique chevauche la première extrémité (302) de la deuxième partie d'écran magnétique dans une direction parallèle à l'axe général de révolution au niveau de la première extrémité de la première partie d'écran magnétique et de la première extrémité de la deuxième partie d'écran magnétique.

12. Dispositif de mesure selon la revendication 10 ou 11, dans lequel, lorsque les premier et deuxième bras du dispositif de mesure sont dans une configuration fermée, les première et deuxième parties d'écran magnétique présentent un axe général de révolution, et dans lequel un premier diamètre de la première extrémité (201) de la première partie d'écran magnétique, par rapport à l'axe général de révolution (V), est supérieur à un deuxième diamètre de la première extrémité (302) de la deuxième partie d'écran magnétique, de telle manière que, lorsque les premier et deuxième bras du dispositif de mesure sont dans une configuration fermée, la première extrémité de la deuxième partie d'écran magnétique est reçue à l'intérieur de la première extrémité de la première partie d'écran magnétique.

13. Dispositif de mesure selon l'une quelconque des revendications 10 à 12, dans lequel la première extrémité de la deuxième partie d'écran magnétique inclut une échancrure (804) pour permettre aux premier et deuxième bras du dispositif de mesure de se déplacer de la configuration fermée jusqu'à une configuration ouverte, et dans lequel les première et deuxième parties d'écran magnétique sont formées de telle sorte que, lorsque les premier et deuxième bras du dispositif de mesure sont dans une configuration fermée, la première extrémité de la première partie d'écran magnétique chevauche l'échancrure de la deuxième partie d'écran magnétique.

14. Dispositif de mesure selon l'une quelconque des revendications 10 à 13, dans lequel la première partie d'écran magnétique présente un axe général de révolution (V), et dans lequel un premier diamètre, par rapport à l'axe général de révolution, de la première partie d'écran magnétique (801, 802) à un emplacement adjacent à l'espace libre (C) entre la première extrémité du premier secteur et la première extrémité du deuxième secteur est supérieur à un deuxième diamètre, par rapport à l'axe général de révolution, de la première partie d'écran magnétique (801, 802) à un emplacement distant de l'espace libre (C) entre la première extrémité du premier secteur et la première extrémité du deuxième secteur.

15. Dispositif de mesure selon l'une quelconque des revendications 1 à 14, dans lequel le dispositif de mesure est un dispositif de mesure de courant de flux magnétique à noyau divisé, et dans lequel le premier élément de détection comprend un élément de détection de flux magnétique.
